# EUROPEAN PATENT APPLICATION

(11) **EP 4 730 390 A1**
(43) Date of publication of application: **22.04.2026**
(21) Application number: 25169634.0
(22) Date of filing: 10.04.2025
(51) Int. Cl.: H01J 37/32, H05H 1/24, B03C 3/09, B03C 3/017

(54) **MULTILAYER PLATE MODULAR CARTRIDGE FOR AGGLOMERATION AND DEPOSITION OF PARTICULATE MATTER IN GAS**

(30) Priority: 21.10.2024 LT 2024018
(71) Applicant: Vilniaus Gedimino technikos universitetas, 10223 Vilnius (LT)
(72) Inventor: Chlebnikovas, Aleksandras, 03225 Vilnius (LT); Kilikevicius, Arturas, 13263 Vilnius district, Nemezis (LT)
(74) Representative: AAA Law

(57) **Abstract**

The invention is considered to be a part of the technology of pre-treatment devices, in which gas contaminated with fine and ultrafine particulate matter is subjected to an adapted electric field, causing the particles to agglomerate - that is, to form coarser formations - with part of them being deposited. The objective is achieved by the use of a bipolar electric cold plasma field unit in the primary zone of the dual-zone working chamber, a multilayer plate modular cartridge consisting of electrically connected modules (8) of identical structure with symmetrically configured rectangular interlayers. Each module is symmetrically shielded on both sides, and the designed internal (10) and external (14) air gaps allow for the parallel movement of the contaminated gas flow. The core of the module is equipped with a metallic conductor (copper-aluminium alloy) foil electrode (12), insulated on both sides by symmetrical inner (11) and outer (13) protective glass insulator plates (11), which act as electrical capacitors. From the single-phase mains (20), the electric current is fed by a primary circuit (21) to a current rectifier (16), a pulse generator (17), and an autotransformer (18), and by a secondary circuit (28) to a high-voltage transformer (19), which then delivers the smoothed DC, bipolar pulsed, and stepped-up voltage to the electrodes of the electrical conductor foil (12).

## Description

### FIELD OF THE INVENTION

The invention is considered to be a part of the technology of pre-treatment devices. In such devices, a gas contaminated with microdispersed and ultradispersed particulates is subjected to an adapted electric field, which then causes the fine and ultrafine particulates to agglomerate, that is, to form coarser formations. The electric field is generated by passing an alternating positive and negative electric potential pulsed high-voltage cold plasma (non-thermal) flow through the formed channels in the cartridge, which induces transverse motion of ultrafine dispersed particulates (less than 1 µm in size) and increases the probability of collision.

### BACKGROUND OF THE INVENTION

Conventional treatment technologies based on gravity, centrifugal, electrostatic and other operating principles are widely used to remove particulate matter (PM). Filters based on these methods are suitable for the removal of PM coarser than 1 µm, however, the removal efficiency of the ultrafine particulate matter (UFPM) fractions from the gas stream using these methods is not sufficient in view of the recommended emission limits and the future perspectives for reducing this type of pollution. Also, existing technologies are not adapted well or are not effective in the case of wide size distribution and/or high concentration of PM in the flow, which is why pre-treatment or specialized treatment of the contaminated flow is required prior to the mentioned widely used filtration technologies. The applicability of such devices as stand-alone treatment units is limited and requires precise selection or redesigning according to the type and characteristics of the PM and the characteristics of the gas flow. Some of the technologies used are energy intensive due to the high aerodynamic resistance of the system, high power electrical systems are used to operate the technology.

Prototype of the invention presented - bipolar electrostatic chuck, described in the US patent No. US20100149720, patent application No. 12691613.

When an electrostatic field is used, PM sizing from 200 nm to 1 µm are agglomerated the most efficiently (Jaworek et al., 2018). In a scientific study (Lin et al., 2020), it was also observed that electric field agglomeration is most effective for UFPM between 100 nm and 1 µm. Electric field agglomeration can agglomerate UFPM with an efficiency of 40.2% when a frequency of 45 Hz and an AC electric field of 9 kV/cm is used, with an effective agglomeration range of 0.1 to 20 µm of PM. During experiments with electric field agglomeration, it has been observed at with a supply voltage of 30 kV, the agglomeration efficiency drops dramatically from 64% to 42% as the flow velocity increases from 1 m/s to 5 m/s (Jia et al., 2024). Agglomeration efficiency also increases with increasing total mass concentration and particle residence time in the agglomerator (Hautanen et al., 2010). Among PM of different sizes, it has been observed that PM with no charge easily slips over larger particles; when particles are given a charge of different polarity, the probability of collision increases strongly (Xu et al., 2021).

The application of an electric field is important for the study of flow electrohydrodynamics. There are studies (Zhou et al., 2023) that deal with devices with electroconvective flow, which is induced by so-called charge spray. Such technology is used for the micro-mixing of liquids as well as for their atomization. Alternating currents with a sinusoidal phase are mainly applied to induce the unipolar electric fields, but changes in alternating and pulsed electric fields and the transition from DC to AC are also investigated. In the case of a unipolar field, the charge carriers are usually assumed to be positive electrons, so the electric potential is calculated using Poisson's equation, which takes into account the charge density (Christen & Seeger, 2007).

A device based on electrostatic charging of small aerosol particles, using an ion current and an alternating electric field, has been investigated (Lackowski, 2001). The gravitational, drag, inertial and electrodynamic forces of the alternating electric field were taken into account in the analysis of the effect on particle motion. The technology is used to charge liquid droplets or particles in electrostatic coating or surface painting, particle separation, electrostatic scrubbers, electrostatic filters and electrostatic precipitators, resulting in improved cleaning efficiency and productivity and/or energy savings. In another study (Jaworek & Krupa, 1989) it was observed that the motion of particles perpendicular to the particle flow is strongly influenced by the electric field applied to them. This approach was based on earlier results stemming from a particle charging method using unipolar ion bombardment in an alternating electric field. According to this method, particles are charged up to the Pauthenier limit, i.e. when a particle enters a medium with a space charge, it acquires a finite charge from the ionised field when the particle becomes charged. In this case, charging the particles in an alternating electric field avoids deposition on one of the electrodes, which is the region where particles oscillate with a small amplitude.

There is a study that investigated the technology of increasing the strength of ceramics to avoid the occurrence of defects in the cyclical exposure zone of a bipolar electric field (Wang et al., 2020). It was found that this field can agglomerate oxygen vacancies in ceramic grains or at grain boundaries during the fatigue process of the material.

The application of a bipolar field and its advantages over a unipolar field are also seen in bioelectrochemical processes. Study has shown that bipolar pulses of the same duration, amplitude and reversed polarity with microsecond pulse widths increase the agglomeration (coarsening) effect by up to a factor of three compared to unipolar fields (Ke et al., 2019). This was found in fusion rate studies with SP2/0 mouse myeloma cells and lymphocytes. It was also observed that the unipolar field is more asymmetric than the bipolar field.

A technological solution using sequential particle charging, their agglomeration and final deposition in an electrostatic precipitator is presented in a study (Tan et al., 2007). In this solution, the particles are first charged by bipolar corona discharges, then they move to the agglomeration chamber where a constant electric field is present. The direction of the constant field strength is determined by the relative position of the two discharge electrodes. In such electric field, particles with opposite charges can be forced to move towards each other and agglomerate more efficiently, as well as be more effectively deposited in the next stage of treatment.

Several authors have already experimentally studied electrical agglomeration. The agglomeration of particles induced by an alternating electric field in a parallel plate of agglomerator was presented in a study (Kobashi, 1979). The agglomeration resulted in a reduction of the concentration of PM sizing 0.3-2 µm by about 30% (Watanabe, 1988). In another study, a so-called quadropolar agglomerator was used. Its operation is based on an electric quadropolar field which concentrates charged particles in the centre of the quadrupole (Masuda, 1970). The results of the study showed that the agglomeration reduced the concentration of PM below 1 µm by about 20%.

For the study, both a parallel plate and a quadropolar agglomerator system was developed, which is capable of reducing the PM concentration of ultrafine dispersions by about 4-8 % (Hautanen et al., 1995). Another study has found that bipolar charging using a parallel plate agglomerator allows to achieve an agglomeration efficiency of ultrafine PM ranging from 17 % and 19 %, in terms of numerical concentration (Laitinen et al., 1996).

***Application of the electric field mechanism.*** The application of additional solid and liquid aerosol treatment technology, before those aerosols reach the main cleaning plant, is considered as an alternative treatment method for PM agglomeration. One approach is to use cold plasma technology, which alters the state of the PM flow and deposits part of the PM using electrostatic force (Zhang et al., 2023).The generation of high energy electrons, ions, reactive groups, excited state molecules and atoms in such type of device allows additional collision-induced physical and chemical reactions to occur. This technology is being scientifically investigated in engine exhaust and industrial gas cleaning systems, where the ion wind effect occurs in the electric field interaction region (Qu et al., 2022). The electric field, and in particular its different characteristics, has a significant impact on changing the flow state when aerodynamic processes are less intense, such as at low flow speeds or in high volume ducts. The electric flow effect allows to increase the PM deposition, in particular by reducing the UFPM weight among all size fractions (Dong et al.,2018;Sobczyk et al.,2017;Tu et al.,2018). The behaviour of the gas flow when the electric field is applied is particularly dependent on the field's characteristics, and its proper control allows to prioritise the composition of the contaminated flow according to the needs, which in this case would mean achieving higher cleaning efficiency.

***Variety of agglomeration mechanisms.*** Different agglomeration mechanisms are known to be effective in the agglomeration of PM, but have limitations due to their selectivity and require certain conditions of application.

In order to improve the efficiency of removal of UFPM from the gas stream, there are various agglomeration technologies that increase the size of the UFPM before it enters the cleaning/treatment plants. Available agglomeration technologies include electric field agglomeration (Jia et al., 2024; Thonglek & Kiatsiriroat, 2014), chemical agglomeration (Y. Guo et al., 2017; Y. Liu et al, 2016), heterogeneous-condensation agglomeration (Yang et al., 2010), turbulent agglomeration (Chen et al., 2016; Sun et al., 2020) and acoustic agglomeration (NG et al., 2017; Sheng & Shen, 2007).

Electrical agglomeration may be accompanied by agglomeration processes of a different nature, which accelerate particle aggregation. Chemical agglomeration involves the injection of a chemical reagent into the PM contaminated gas stream. Physical and chemical processes are used to promote the collision and agglomeration of PM, and such chemical agglomeration technology has the potential to aggregate PM into larger formations (Bin et al., 2018; Guo et al., 2017). Agglomeration occurs in an operating chamber by injecting a chemical reagent into the chamber and using compressed air. The agglomeration efficiency for UFPM sizing between 0.1 and 1 µm is 62.9% without the addition of chemicals, while the efficiency is 82.8% with the addition of water 68.1%, pectin 77.6% and sodium alginate (Bin et al., 2018). Chemical agglomeration can efficiently agglomerate PM ranging from 0.03 to 10 µm (Sun et al., 2019). However, using chemical agglomeration brings the problem of how to remove residual chemicals from the gas stream, and this technology may also be limited by the use of materials that are prone to the applied chemicals, which can lead to corrosion and changes in their mechanical properties.

Heterogeneous-condensation agglomeration consists of vapour condensate and PM, creating an agglomerated PM aerosol (Yang et al., 2010). Heterogeneous condensation as a preconditioning technique is particularly suitable for gas streams with high moisture content. This technology is ideal for agglomeration of contaminated high temperature and high humidity gas streams, for example for the removal of wet dust. Wood ash PM in the boiler flue gas stream is ranging between 2,5 and 10 µm in size and the total volume of PM in the flue gas stream is reduced by more than 55 % after agglomeration. Effective agglomeration using this technology is possible for PM ranging from 0.2 to 10 µm (Liu et al., 2017). However, to obtain a non-condensable gas stream in the outlet, it is necessary to use moisture absorbers or other methods to remove vapour. In addition, condensation agglomeration technology would be difficult to combine with electric circuits due to safety in operation. In addition, it is necessary to address the removal of the PM accumulated in the condensate, which, depending on the type of pollutant, may dissolve or form a viscous solution when mixed with water.

Acoustic agglomeration affects the UFPM in the gas stream, altering their movement and causing collisions and coalescence. The newly formed PM formations continue to agglomerate, leading to a sequential aggregation of particles (NG et al., 2017). In an acoustic field, particles are subjected to different orthokinetic and hydrodynamic interaction mechanisms, while other effects such as acoustic flow and turbulence further promote the coagulation process. After the collision, the particles stick together due to their irregular structures and intermolecular attractive forces. Differential fluid and inertial forces in the acoustic field oscillations cause the particles to engage with different amplitudes and phases. Relative motions between particles of different sizes cause collisions (NG et al., 2017; Sheng & Shen, 2007). Acoustic pollution is considered to be one of the drawbacks of this approach, which is unavoidable in the absence of a fully isolated system and therefore has significant limitations in open installation systems. Also, high sound level and ultrasonic generators have to be selected according to the need, therefore the agglomeration system composed of them cannot be easily adjusted and has to be individually selected in order to be applied to different technological processes.

Orthokinetic mechanisms of the acoustic effect occur between particles of different sizes at a distance approximately equal to the amplitude of the acoustic field displacement and whose relative motion is essentially parallel to the direction of vibration (Sheng & Shen, 2007). The hydrodynamic interaction mechanism describes collisions resulting from the viscous interaction between particles and the surrounding medium, and it can occur for particles that are separated by distances much larger than their acoustic displacement amplitudes. Hydrodynamic forces consist of the mutual wave pressure interaction and acoustic excitation. The mutual radiation pressure interaction is due to the non-linear interaction between incident and scattered waves, which distribute the sound pulse between the surrounding PM. This results in pressure gradients on different sides of the particle, and thus attraction and repulsion zones around PM (Hoffmann & Koopmann, 1997). The acoustic excitation effect accounts for the nonlinear interaction of the scattered waves and the drag reduction experienced by the particle travelling behind the leading one. As a result, the trailing particle moves towards the leading particle at a higher velocity and sticks with it on impact. This effect is significant for PM agglomeration at high acoustic intensities and for particles of similar size. (NG et al., 2017).

High-frequency (6,4 kHz) sound waves with a maximum sound pressure level of 140 dB could be used to subject ultrafine dispersed PM of 0,4-0,5 µm in size moving with the gas flow in the acoustic field and to transform them into agglomerates of 0,6-0,8 µm, with an efficiency of up to 16 %. Acoustic agglomeration can efficiently agglomerate PM from 0.06 µm to 0.8 µm (NG et al., 2017). The highest efficiency is achieved when the sound pressure level is within a very narrow frequency range of 150 to 160 Hz. Higher sound waves are energy-intensive and may increase the need for attenuation of the noise generated (J. Xu et al., 2023).

In an electric field generator, the agglomeration process involves a biphasic flow consisting of a gas stream and aerosol particles that are trapped between flat electrodes between which a bipolar electric field is created by applying an alternating electric voltage, and the PM that enters the field begins to agglomerate. The agglomeration efficiency can be adjusted by the magnitude of the supply voltage, the frequency of the supply voltage and the speed of the gas flow through the unit.

Conventional methods of gas stream cleaning are insufficient to achieve the required level of purification. An increasing number of research focuses to removal of PM. Most of the research is focused on the clean-up of polluted gas emissions from energy production sources possibilities, both at the scale of individual devices and for an entire process line or industrial site. For example, emissions from different types of solid fuel combustion boilers are investigated. Gas stream dilution technologies to reduce PM concentrations are being investigated (Abdul-Khalek et al.,1999). There are scientific papers describing the results of studies on gas stream cleaning when liquid fuels from renewable sources are used, as well as experimental data obtained under natural conditions from the combustion of edible oil (Chlebnikovas et al.,2022).

The prototype of the present invention is the Bipolar electrostatic chuck, described in US Patent No US20100149720, Patent Application No 12691613.

The invention is designed to electrostatically attract and hold a sample under the influence of a bipolar electrostatic field. The device is composed of a metal base in the outer part (6), a lower insulating layer (5), a multilayer electrode of single sign potential consisting of a primary electrode in the form of a grid (24) and a secondary electrode with a stripe as band-like portions (4a,14a) and a root portions part (4b,14b). An interelectrode insulating layer (3) is arranged between the electrodes of different sign polarity (or potential). This is followed by a front multilayer electrode of opposite sign potential (2) consisting of a primary electrode (24) which has a collector part as root portion (2b) and spacers as a band-like portion (2a) interspaced by gaps (12a), a secondary electrode in the form of a grid (12) and a tertiary electrode which has a circular part in the centre and an annular part at the periphery with a connector part. Above all the layers there is arranged a sample attracting plane (7), a glass layer (9) with an insulating material (9). The multilayer electrodes of different sign potentials are connected in a DC circuit with a power supply. The device uses a supply voltage of 1,5 kV at which a high gradient force is generated and which is capable of ensuring continuous attraction and holding of the sample. In addition to the induced traction force, the device also utilizes the Coulomb force, which has an attraction capacity of approximately 100 gf/cm2, without gradient force. As a result, the bipolar electrostatic chuck can be used to attract and hold a sample made of a semiconductor substrate such as a silicon wafer. In other words, the use of a bipolar electrostatic field allows the application to attract samples made of an insulating substrate, such as glass, as well as those made of a semiconductor substrate, such as silicon.

Fine dispersed particulate matter (less than 5 µm) and very fine dispersed particulate matter (less than 1 µm) can easily enter and accumulate in the lungs and respiratory tract and the alveoli, and especially small particulate matter can be released into the bloodstream, leading to inflammation and acute illnesses.

***Widely used modern electric field technologies.*** The technologies used to treat the gas stream are based on the characteristics of the pollutants and the parameters of the plant process line. Typical cyclone-type units are used in many configurations with efficiencies of up to 90% for PM below 5 µm (Honda et al., 2020; Sati et al., 2020). The installation of an electrostatic apparatus is exclusively suitable for fine cleaning or recovery of the process fraction; however, it has many limitations as an stand-alone device and the operation of the electrical system requires special expertise (Bekkara et al.,2021; Feng et al.,2016; Gajbhiye et al., 2015; Guo et al., 2015).

More and more electric field technologies using different electric current characteristics by changing the normal sinusoidal phase change to a pulsed phase are being applied. This way a unipolar field is replaced with a more efficient bipolar field, quadripolar field, etc. Of course, a more complex current modification circuit requires additional components to modify its characteristics, increasing the cost, maintenance, and control complexity of the system, while the efficiency may not improve significantly. A pulsed electrical signal allows the amplitude of the electrical current to be controlled by varying the voltage and hence the electrical current. Also, using an electric current frequency converter in the system circuit, it is possible to vary the duration of each repeating pulse, both of positive and negative potential, relative to the duration of the whole phase. These manipulations make it possible to modify the effect of the electric current source on the surrounding environment and to induce positive outcomes in the agglomeration process.

PM removal is considerably simpler technologically and factually higher with a more homogenised dust stream - when there is a uniformity of flow, small range of concentration and size. The multichannel cyclone is a relatively recent development for the treatment of contaminated gas streams with a high concentration and relatively wide range of fine dispersed PM and coarser PM below 50 µm. However, the centrifugal forces applied in the cyclone are not sufficient to deposit the finely dispersed PM moving in the turbulent air flow. The removal of finely dispersed PM is achieved using electrostatic air filters (Bekkara et al., 2021; Feng et al., 2016; Gajbhiye et al., 2015; Guo et al., 2015). However, these filters, which can operate in high concentration PM gas flow environments, are bulky due to the nature of the technology, i.e. the large distances between the charging and deposition electrodes and just large dimensions, and are therefore not suitable for small flows and mobile devices (Li et al., 2019; Salleh et al., 2019; Zheng et al., 2017). There are studies on the application of conventional treatment devices under specific environmental conditions and PM agglomeration, which makes maintenance of such technologies difficult (Nouri et al., 2016; Sarabia et al., 2003; Yan et al., 2022).

### THE SUMMARY OF THE INVENTION

The goal of the present invention is to create a treatment and deposition device for the treatment and deposition of a dry contaminated gas stream, in particular for the agglomeration of fine dispersed and ultra-fine dispersed PM present in the gas stream and for the creation of a bipolar electric field which creates a hydrodynamic force that excites the particles. The objective is achieved by the use of a cold plasma unit located in the primary zone of the working chamber, with a gap between that unit and the bottom of the chamber, a series of parallel interconnected isolated modules, to which the gas flow enters through a common inlet, and rectangular symmetrically configured interlayers for each module.

The inlet is located in one of the side walls in the vertical and horizontal symmetry axis so that the contaminated gas stream enters the primary zone of the working chamber, where it is uniformly spread, and some of the coarsest PM are deposited by gravity forces. The primary and secondary zones of the working chamber are connected by air gaps located in the centre of the interlayers of each module. The flow of contaminated gas is directed towards the secondary zone of the working chamber by fully isolating the upper and lower edges of each module. The gap between the multilayer plate module cartridge and the bottom of the working chamber smooths the mixing of the flows, avoids additional pressure losses and prevents adhesion of PM to the multilayer plate module cartridge elements.

***Uniqueness of the invention.*** In order to improve the degree of removal of fine dispersed PM and UFPM from the gas stream, it is possible to apply an agglomeration mechanism to reduce the amount of such particles in the gas stream by aggregating them into coarser formations. The glass plates act as a planar capacitor for eletrical breakdown at field strengths greater than 2,1 kV/cm, each glass plane receives the current from its own electrode-foil. Both of these electrodes are of the same sign and they transfer the charge to the particles moving with the flow. This system allows an electrostatic field to be generated at a much higher voltage than the increase in current strength. As the charge is transferred to the particles, they begin to move at higher speeds, increasing the probability of collision, which causes agglomeration. The whole housing, together with the outer insulating plates, is grounded and therefore has an opposite charge. Particles that become charged due to the barrier discharge are partially deposited on the housing, which carries the opposite charge. This process slightly reduces the concentration of particles in the air stream.

The effects of this patented invention on the pollutants present in the gas stream can be different. Due to the low gas flow velocity, the high density and large diameter PM may be affected by spontaneous deposition phenomena due to the high drift velocity, and the invention will therefore act as a deposition chamber. The essential mechanism is that of a PM agglomeration device, and therefore in the chain of treatment plants it has to be installed after a coarse pre-treatment device such as a centrifugal deposition tank, removing only particularly coarse PM which may cause technical difficulties in operation, whereas the present patented invention can be followed by a conventional filter that receives a gas stream containing the agglomerated PM.

This device is classified as a dry and semi-humid (up to 50% relative humidity) gas flow device and can be used in a wide range of industrial applications and/or workplaces and/or administrative areas where PM formation is likely.

The invention can be applied to a gas flow with a volume flow rate varying in the range from 2 I/min to 50 I/min. The variation of the aerodynamic drag has been investigated in a system of the present invention that is being patented, using a multilayer plate modular cartridge consisting of eight parallel modules in the working chamber (Table 1).

**Table 1. Aerodynamic drag of a multilayer plate modular cartridge in relation to gas volume flow rate for an eight-module cold plasma unit.**

| | | | | | | | | | | |
|---|---|---|---|---|---|---|---|---|---|---|
| **Proportion of nominal capacity of gas volume flow rate, %** | 10 | 20 | 30 | 40 | 50 | 60 | 70 | 80 | 90 | 100 |
| **Gas volume flow rate, I/min** | 2,2 | 4,4 | 10,1 | 16,1 | 22,4 | 28,1 | 35,1 | 43,1 | 52,9 | 56,8 |
| **Aerodynamical drag, Pa** | 8 | 16 | 33 | 49 | 68 | 88 | 109 | 133 | 162 | 175 |

### DESCRIPTION OF DRAWINGS

The figures show images of the multilayer plate modular cartridge for agglomeration and deposition of particulate matter in the gas, where:

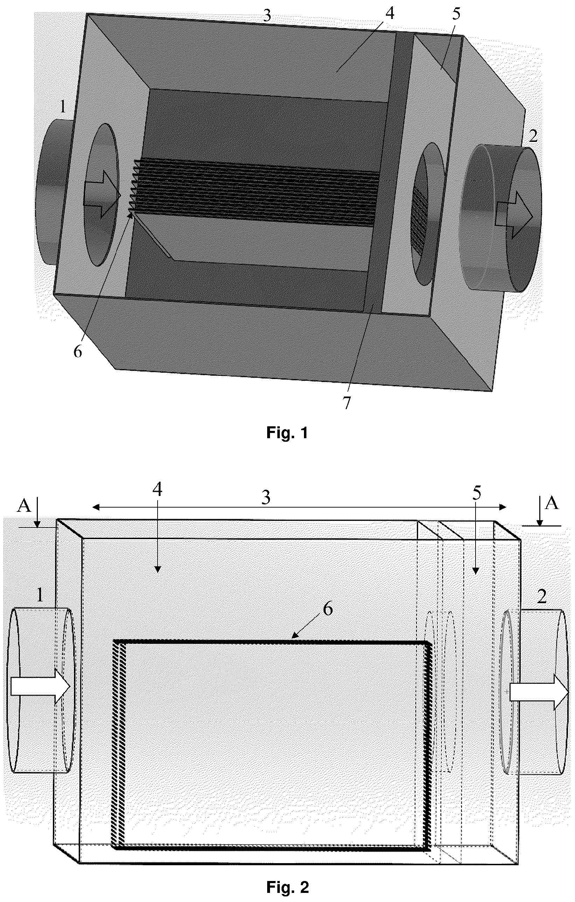

- Fig. 1: is an axonometric view of the working chamber of the multilayer plate modular cartridge of the present invention, without the chamber cover;
- Fig. 2: is a schematic cross-sectional view of a working chamber of a multilayer plate modular cartridge of the present invention through line A-A of Figure 2;

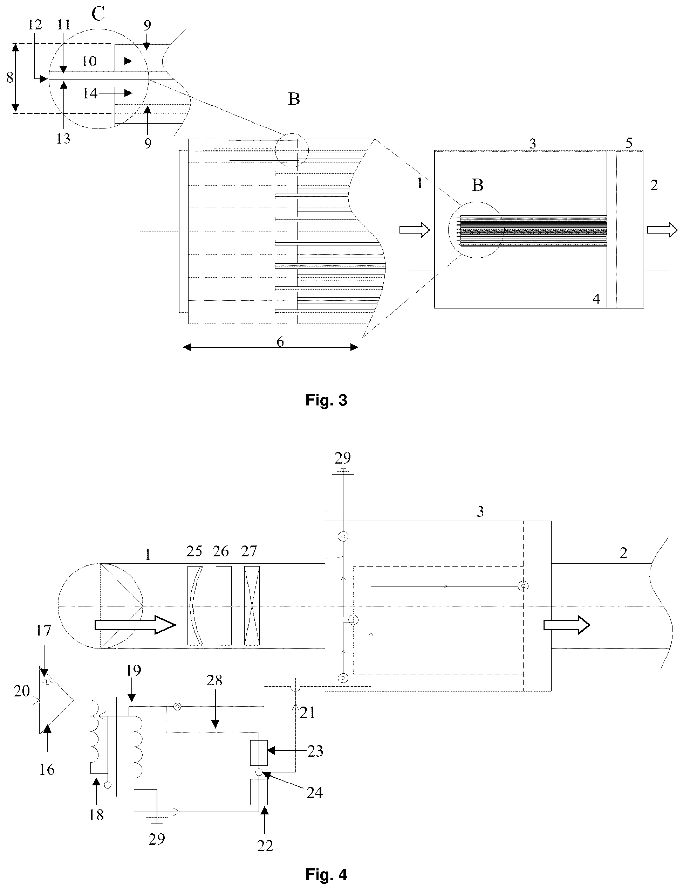

- Fig. 3: is a schematic view of the multilayer plate modular cartridge system of the present invention, and details of multilayer plate modular cartridge B and module C;
- Fig. 4: is a schematic diagram of the electrical circuitry of the multilayer plate modular cartridge of the present invention.

### DETAILED DESCRIPTION OF A PREFERRED EMBODIMENT

A multilayer plate modular cartridge system comprises an inlet gas duct 1 for contaminated gas (together with a stream of not yet agglomerated PM), a gas (together with a stream of agglomerated PM) outlet duct 2, a working chamber 3, which is composed of a primary zone 4 and a secondary zone 5. The primary zone 4 is equipped with a multilayered plate modular cartridge 6 consisting of modules 8 of identical structure, each internally shielded by a symmetrical metallic stainless steel plate 9, each module 8 is equipped with an internal air gap 10 for the parallel movement of the contaminated gas stream, the inner air gap 10 is bordering an inner protective glass insulator plate 11, which insulates the metallic electrical conductor (copper-aluminium alloy) foil electrode 12, that generates a bipolar electric cold plasma field, on the inner side, while the outer protective glass insulator plate 13 insulates it on the outer side. The outer glass insulator plate 13 is bordered on the other side by an external air gap 14, which in turn is shielded symmetrically on the outer side by a metal plate 9. The multilayer plate modular cartridge 6 thus consists of a series of parallel modules 8 of analogous geometry, in which the electrodes 12 are connected in series and connected to the primary circuit 21 with a current rectifier 16 and a pulse generator 17, an autotransformer 18 and a high voltage transformer 19. The working chamber 3 and the secondary circuit 28 are grounded at connections 29.

**Operating principle of the device.** A fan or no device (if the gas stream originates as a consequence of a technological process) delivers the gas contaminated with a yet non-agglomerated PM stream- the biphasic stream - to the cold plasma bipolar electric field system of the cold plasma multilayer plate modular cartridge through the inlet gas duct 1. The biphasic flow then passes through an opening designed in the horizontal and vertical symmetry axis of the smaller wall area of the working chamber 3 into the primary zone 4 of the working chamber 3. In this zone, due to more than 5 times larger cross-sectional area of the channel, the incoming gas flow is laminarized over the entire length of the zone, which is more than 30 % greater than the width or height of the zone,. The primary zone 4 is separated from the secondary zone 5 by an inner wall 7, so that the gas flow with the PM can only move through the inner 10 and outer 14 air gaps in the identically structured modules 8 of the multilayered plate modular cartridge 6. Due to the force of gravity, some of the PM larger than 20 µm in size moving with the gas stream is deposited in this zone, thus allowing the chamber to act as a deposition-purifying device, while at the same time removing the coarsest particles from the gas stream, which could lead to blockages in the internal air gaps 10 and/or external air gaps 14 of the identically structured modules 8 of the multilayered plate modular cartridge 6, where active agglomeration of fine dispersed particles and ultrafine dispersed PM takes place.

The length of each module 8 is in a 6:7 ratio to the length of the primary zone 4 of the working chamber 3. Each module is spaced at a distance equal to 1/7 of the length of this zone from the plane of the smaller wall of the working chamber 3, which is equipped with an inlet. The positive pressure created in the primary zone 4 causes the gas stream to pass through the internal air gaps 10 and the external air gaps 14 of the multilayered plate modular cartridge 6, which is made up of identically structured modules 8, before entering the secondary zone 5 of the working chamber 3. The multilayer plate modular cartridge 6 is sealed on all sides, except for the inner air gaps 10 and the outer air gaps 14, and is raised above the bottom of the working chamber 3 in such a way as to form an air gap having a height equal to 7,5 % of the total height of the working chamber 3. The inner air gaps 10 and the outer air gaps 14 are arranged in such a way that each module is symmetrically shielded on both sides by a stainless steel metal plate 9. The thickness of the metallic stainless steel plate 9 shall be at least 50 % of the width of the inner air gap 10 and/or the outer air gap 14. On the other side, the inner 10 and outer 14 air gaps are symmetrically bordering the inner protective glass insulator plate 11 and the outer protective glass insulator plate 13, respectively.

The invention incorporates tempered glass which also acts as a capacitor over its entire surface area, which is arranged parallel to the foil electrode 12 of the metallic electric conductor, and which has a thickness of approximately 15 times the thickness of the foil electrode 12. Each of the electrical conductor foil electrodes 12 creates zones of active agglomeration in each of the inner 10 and outer 14 air gaps installed in each of the modules 8. The electrical conductor foil electrode 12 is insulated symmetrically on both sides by an inner 11 and an outer 13 protective glass plate insulator. The opposite edges of the inner 10 and outer 14 air gaps are located on both sides of the conductor foil electrode 12 at a distance of 2,7 mm or less from the conductor foil electrode 12, which ensures the propagation of the electric field through the entire volume of the air gaps, thus making the overshoot or skipping of particles unlikely and the probability of not being exposed to the cold plasma of a bipolar electric field minimal. Each of the electrical conductor foil electrodes 12 in the module 8 is connected in series with each other and connected to the primary eletrical circuit 21, while the working chamber 3 and the secondary circuit 28 are grounded to the connectors 29. The conductor foil electrodes 12 have a thickness of 55 µm, which allows high voltages to be supplied through the electrical circuit without significant energy loss.

The energy is supplied from the single-phase electrical grid 20 by a primary circuit 21, which is fed to a current rectifier 16, where the current is converted to direct current. The current is then fed to a pulse generator 17, from which it is directed by bipolar pulses to an autotransformer 18, which is capable of varying the voltage of the current from 0 to 250 V. The current is then fed by a secondary circuit 28 to a high-voltage transformer 19, where the voltage is amplified and fed to the electrodes of the electrical conductor foil electrodes 12. Such a complex circuit allows the characteristic of the current to be altered from the normal sinusoidal alternating voltage 20. Using the pulse generator 17, the change in the electric current in each phase is converted into a pulsed bipolar change, both of positive potential and negative potential, where the amplitude of each pulse is equal to the voltage of the electric current.

It is also possible to connect a synthesiser to the circuit in the current rectifier 16 and the pulse generator 17 to vary the frequency of the applied electric current, thereby varying the duration of the cold plasma pulse of the bipolar electric field, that is to say, the width of this pulse, which is defined by the fraction of time relative to the total phase, which is, in turn, equal to the wavelength of electric current.

Meanwhile, the high voltage transformer 19, which uses a high (up to 1 TΩ) resistor (voltage sensor) 24, allows the control of the voltage 22 (up to 5 kV in the present invention) and the amperage 23 (up to 7 mA in the present invention).

In this invention, higher current voltages would cause a cold plasma electrical breakdown, i.e. the condition of not exceeding 300 V at a distance of 1 mm between adjacent cold plasma sources would not be met, which would make the system unstable. However, to extend these characteristics it is possible to increase the spacing between each adjacent module 8 of identical structure, which would significantly increase the dimensions of the multilayered plate modular cartridge 6. For safe operation, the housing of the working chamber 3 is provided with a ground connection via circuit 29. After the gas flow with the agglomerated PM stream has passed through the inner air gaps 10 and outer air gaps 14, it passes in parallel paths from the air gaps 10 and 14 into the secondary zone 5 of the working chamber 3. This zone is intended to laminarize the gas flow prior to leaving the working chamber, with a cross-sectional area of more than 15 times the total area of all the inner air gaps 10 and outer air gaps 14, and with a length in relation to the total length of the working chamber 3 of about 1:8. Finally, the flow of gas and agglomerated PM through the opening, located on the opposite side of the working chamber 3 from the inlet gas duct 1 and in the horizontal and vertical axis of symmetry of analogous wall with a smaller area, passes into the gas outlet duct 2. The degree of agglomeration of the PM caused by the bipolar electric field in the cold plasma depends not only on the characteristics of the electric current, but also on the volume flow rate of the moving gas stream and the nature of the PM, i.e. its dispersive composition and its electrical properties.

To achieve the agglomeration of fine and ultra-fine dispersed PM in the gas, a multilayer plate modular cartridge 6 is used, the length of which provides a contact time of approximately 0,1 seconds for the PM, i.e. a residence time in the active agglomeration zone. This ensures the exposure of the PM and allows the manipulation of their transverse motion, thus significantly increasing the probability of their collision and coalescence, i.e. agglomeration. The repetitive variation of the opposite potentials of the bipolar electric field at each pulse makes it possible to induce agglomeration even in high resistance PM, which considerably extends the application of the invention. The agglomeration of PM is also due to collisions and autohesion between PM caused by the longitudinal motion of the gas flow. In addition, the intensity of agglomeration of PM is increased at higher relative humidity in the gas stream when an additional film of water or other liquids is formed on the surface of the PM, which increases the autohesive force and makes it less likely that the PM will elastically rebound in the event of collision.

The invention may be accompanied by a PM charge neutraliser 25 or a positive (or negative if needed) potential ioniser 26. The neutraliser 25 removes the charges present in the PM, leading to a neutral PM flow, then the electrostatic forces between the PM will be kept to a minimum and will prevent the pushing forces between the PM of the same charge from acting on the PM thus increasing their agglomeration. In the ioniser, the 26 PM can be charged to the required potential sign and sufficient charge to be deposited on the inner surfaces of the bipolar electric field cold plasma multilayered plate modular cartridge with opposite potential sign and then intense adhesion would take place, but in this case agglomeration between the PM of the same potential sign would be minimal.

The inlet gas duct 1 of the invention is equipped with a gas flow equalizer 27, the geometry of which comprises an arrangement of metallic grids, which is capable of breaking up the eddies in the gas flow. Possible unevenness caused by the fan or other possible local obstructions installed in the system prior to the invention allows the gas flow to be stabilised without significant pressure loss in the straightener 27.

In operation, the bipolar electric field cold plasma multilayer plate modular cartridge 6 may be used with a varying number of modules 8, depending on the PM concentration in the contaminated gas stream. The higher the concentration of PM, the higher the number of modules 8 must be, but this requires more energy resources. Also, reducing the number of modules 8 allows the aerodynamic resistance of the invention to be reduced and the design to be used in lower capacity systems.

## Claims

1. Bipolar electric field cold plasma multilayer plate modular cartridge for agglomeration and deposition of solid particles in a gas, comprising a working chamber separated into primary and secondary zones, a single axis inlet gas duct and an outlet gas duct, **wherein** the multilayer plate modular cartridge consists of identical modules (8), each having a multilayered plate structure of the same height, shielded on both sides by symmetrical metallic stainless steel plates (9); the gas flow passes through parallel internal (10) and external (14) air gaps located in each module (8); the inner air gap (10) is adjacent to the inner glass insulator plate (11), which insulates the metal conductor (copper-aluminium alloy) foil electrode (12) on the inner side, while the outer glass insulator plate (13) insulates the metal conductor (copper-aluminium alloy) foil electrode (12) on the outer side; the system further comprises a primary circuit (21) for generating a tunable bipolar electric field and a secondary circuit (28) for amplifying and transmitting the rectified bipolar pulsed electric current to the series-connected metal conductor (copper-aluminium alloy) foil electrodes (12).

2. Bipolar electric field cold plasma multilayer plate modular cartridge according to claim 1, **wherein** the modules of the identical structure consist of interconnected plate-shaped elements with internal (10) and external (14) air gaps, each with a width in a ratio to the width of the module (8) of 1:4.

3. Bipolar electric field cold plasma multilayer plate modular cartridge according to claim 1, **wherein** the electrical conductor foil electrode (12) is insulated symmetrically on both sides by an inner (11) and an outer (13) protective glass insulator plate, and that the distance from the electrode (12) to the outermost edge of the air gap is in a ratio of not more than 1:3 to the total width of the module (8).

4. The bipolar electric field cold plasma multilayer plate modular cartridge according to claim 3, **wherein** the width of the electrical conductor foil electrode (12) is in a ratio to the total width of the module (8) as 0,75:100, and symmetrically on both sides, the inner (11) and outer (13) protective glass insulator plate acts as a capacitor, each having a width ratio to the width of the electrical conductor foil electrode (12) as 15:1.

5. Bipolar electric field cold plasma multilayer plate modular cartridge according to claim 1, **wherein** the working chamber comprises a primary zone (4) and a secondary zone (5) with a length ratio of 7:1, which are separated from each other and where the gas flow passes from one to the other only through the inner (10) and outer (14) air gaps.

6. Bipolar electric field cold plasma multilayer plate modular cartridge according to claim 1, **wherein** the length of each module (8) is in a ratio 6:7 to the primary zone (4) of the working chamber (3), and is offset by 1/7 of the length of this zone from the plane of the wall of the smaller area of the working chamber (3) in which the inlet gas duct (1) is installed, and is raised above the bottom of the working chamber (3) so that the height of the air gap is in a ratio to the height of the entire working chamber of 1 in 12.

## Amended claims

### Amended claims in accordance with Rule 137(2) EPC.

1. A bipolar electric field cold plasma multilayer plate modular cartridge (6) for agglomeration and deposition of solid particles in a gas decontamination device comprising a working chamber (3) separated into primary (4) and secondary (5) zones, a single axis inlet gas duct (1) and an outlet gas duct (2),
**wherein** said multilayer plate modular cartridge (6) comprises a plurality of identical modules (8), each module (8) having a multilayered plate structure, said structure is shielded on both sides by symmetrical metallic stainless steel plates (9); where the gas flow passes through a first and a second parallel air gaps (10, 14) located in each module (8); the first air gap (10) is adjacent to a first glass insulator plate (11), which insulates a metal conductor foil electrode (12) on one side, while a second glass insulator plate (13) insulates said metal conductor foil electrode (12) on the other side; the cartridge (6) is arranged for connecting it electrically to a high-voltage generator comprising a primary circuit (21) for generating a tunable bipolar electric field, and a secondary circuit (28) for amplifying and transmitting a pulsed electric current to the metal conductor foil electrodes (12) in the plurality of the identical modules (8).

2. The cartridge (6) according to claim 1, **wherein** in each of the modules (8) having the first (10) and the second (14) air gaps, each air gap (10, 14) has a thickness in a ratio to the thickness of the module (8) of 1:4.

3. The cartridge (6) according to claim 1, **wherein** the electrical conductor foil electrode (12) is insulated symmetrically on both sides by the first (11) and the second (13) protective glass insulator plate, and that the distance from the electrode (12) to the steel plates (9) surface is in a ratio of not more than 1:3 to the total thickness of the module (8).

4. The cartridge (6) according to claim 3, **wherein** the thickness of the electrical conductor foil electrode (12) is in a ratio to the total thickness of the module (8) as 0,75:100, and symmetrically on both sides, the first (11) and second (13) protective glass insulator plate acts as a capacitor, each having a thickness ratio to the thickness of the electrical conductor foil electrode (12) as 15:1.

5. The cartridge (6) according to claim 1, **wherein** the thickness of the metallic stainless steel plate (9) is at least 50 % of the thickness of the first air gap (10) and/or the second air gap (14) within the multilayered module (8), and said first and second air-gaps (10, 14) border the first and second protective glass insulator plates (11, 13) symmetrically.

6. The cartridge according to claim 1, **wherein** the metal conductor of the foil electrodes (12) is a copper-aluminum alloy.

7. A system for agglomeration and deposition of solid particles in a gas flow, comprising
- the bipolar electric field cold plasma multilayer plate modular cartridge (6) according to any one of claims 1 to 6,
- a working chamber (3, 4) comprising a gas inlet duct (1) and outlet duct (2) wherein said cartridge (6) is installed within said working chamber (3, 4) in between said inlet duct (1) and outlet ducts (2), and
- a high-voltage generator connected electrically and configured to generate bipolar pulsed voltage to said cartridge (6).

8. The system according to claim 7, **wherein** the working chamber (3) comprises a primary zone (4) and a secondary zone (5) with a length ratio of 7:1, which are separated from each other and where the gas flow passes from the primary zone (4) to the secondary zone (5) only through the first (10) and second (14) air gaps of the cartridge (6).

9. The system according to claim 7, **wherein** the length of each module (8) of the cartridge (6) is in a ratio 6:7 to the primary zone (4) of the working chamber (3), and is offset by 1/7 of the length of this primary zone (4) from the plane of the working chamber (3) wall in which the inlet gas duct (1) is installed, and the cartridge (6) is raised above the bottom of the working chamber (3) so that the height of the air gap between said bottom and the catridge (6) is in a ratio to the height of the entire working chamber as of 1 to 12.

10. The system according to claim 7, **wherein** the length of the secondary zone (4) of the working chamber (3) makes up 1:8 of the total length of the working chamber (3).

11. The system according to claim 7, **wherein** the generator of bipolar high-voltage comprises a primary circuit (21) with a current rectifier (16), pulse generator (17), autotransformer 18, and high-voltage transformer, and a secondary circuit (28) to the high-voltage transformer (19), configured to deliver the smoothed DC and further transformed to bipolar-pulsed and stepped-up voltage to the electrical conductor foil electrodes (12).

12. Use of the system according to claim 7 comprising the cartridge (6) consisting of eight parallel modules (8) in the working chamber (8) **wherein** the applied gas flow through the system is with a volume flow rate within the range from 2 to 50 I/min.
